# EUROPÄISCHE PATENTSCHRIFT

(11) **EP 0 602 322 B1**
(45) Veröffentlichungstag und Bekanntmachung des Hinweises auf die Patenterteilung: **05.11.1997**
(21) Anmeldenummer: 93114022.2
(22) Anmeldetag: 02.09.1993
(51) Int. Cl.: C23C 14/34

(54) **Zerstäubungstarget mit Targetkacheln**
Sputtering target having target tiles
Cible de pulvérisation avec tuiles

(30) Priorität: 14.12.1992 DE 4242079
(43) Veröffentlichungstag der Anmeldung: 22.06.1994
(73) Patentinhaber: Balzers und Leybold Deutschland Holding Aktiengesellschaft, 63450 Hanau (DE)
(72) Erfinder: Szczyrbowski, Joachim, Dr., D-63773 Goldbach (DE)

(56) Entgegenhaltungen:
- EP-A- 0 393 344
- PATENT ABSTRACTS OF JAPAN vol. 12, no. 248 (C-511)13. Juli 1988 &JP-A-63 035 769
- PATENT ABSTRACTS OF JAPAN vol. 12, no. 248 (C-511)(3095) 13. Juli 1988 &JP-A-63 035 770
- PATENT ABSTRACTS OF JAPAN vol. 4, no. 98 (C-18)(580) 15. Juli 1980 &JP-A-55 058 370

## Beschreibung

Die Erfindung betrifft ein Target für eine in einer evakuierbaren mit einem Prozeßgas flutbaren Prozeßkammer angeordneten Kathode einer Vorrichtung zum Beschichten von Werkstücken mit einem Kathodenkörper und mit einer Vielzahl auf dem Kathodenkörper in einer Reihe nebeneinanderliegend angeordneter, zusammen das Target bildende Targetkacheln und mit mindestens einer zwischen den Targetkacheln und dem Kathodenkörper angeordneten Targetgrundplatte. Ein solches Target ist aus US-A-5 066 381 bekannt.

In Sputterprozessen werden oftmals brüchige Materialien als Quelle (Target) benutzt. Zu solchen Materialien gehören z.B. Silizium (Si) und Indiumzinnoxid (ITO).

Insbesondere in der Glasbeschichtungsindustrie werden Sputteranlagen mit Magnetronkathoden bis zu 4000 mm Länge verwendet. Das abzuscheidende Material wird dabei in Form einer planparallelen Platte, die aus einem oder mehreren Stücken zusammengesetzt ist, auf einer Targetgrundplatte befestigt. Während des Sputterprozesses wird ein überwiegender Teil der Versorgungsleistung an der Kathode als Wärme abgegeben. Um einen langfristig stabilen Sputterprozeß zu gewährleisten muß das Targetmaterial intensiv gekühlt werden.

Ein Bondtarget aus einem brüchigen Material wird indirekt gekühlt. Die erzeugte Wärme wird dazu über die Wassergekühlte Targetgrundplatte abgeführt. Um eine gute Kühlung zu gewährleisten, muß das Targetmaterial einen guten Wärmekontakt zur Grundplatte und muß die Grundplatte eine hohe Wärmeleitfähigkeit haben.

Bei bruchempfindlichen Werkstoffen kann eine guter Wärmekontakt nur durch Kleben oder Löten des Targetmaterials zur Grundplatte erreicht werden. Ein festes Aufdrücken (Pratzen) ist wegen der Bruchempfindlichkeit des Targets ausgeschlossen. Kupfer hat eine sehr gute Wärmeleitung und ist darüberhinaus auch preiswert, weshalb Targetgrundplatten oft aus Kupfer gefertigt werden. Beim Sputtern mit hoher Leistung können Temperaturunterschiede zwischen der Targetoberfläche der Targetbondfläche und der Targetgrundplatte bis über 100 ° C entstehen. Da die Grundplatte und das Target aus verschiedenen Materialien mit verschiedenen Ausdehnungskoeffizienten angefertigt sind, entsteht bei Großtargets eine sehr hohe Spannung an der Grenzfläche Target-Targetgrundplatte. Dies führt sehr oft zur Verformung und auch zur Abtrennung des Targetmaterials von der Grundplatte. Um dies zu vermeiden muß das Targetmaterial für eine Großflächenbeschichtungskathode aus mehreren Stücken zusammen gesetzt werden und eine sehr gute und temperaturbeständige Haftung zur Grundplatte haben.

In der Praxis wird ein Silizium- oder ITO-Target aus mehreren Kacheln zusammengesetzt. Diese Kacheln werden auf eine Kupferplatte von der Kathodengröße geklebt oder gelötet.

Erfahrungsgemäß ist es jedoch außerordentlich zeitaufwendig und schwierig ein Großtarget (z.B. über 2 m Länge) durch Kleben zu fertigen. Um eine gute Haftung zu ermöglichen, wird der Kleber in der Praxis bei hoher Temperatur (bis 180° C) ausgehärtet. Bei der Abkühlung des fertigen Targets auf Zimmertemperatur entstehen auf Grund der unterschiedlichen Ausdehnungskoeffizienten enorme Spannungen zwischen der Kupfergrundplatte und dem Targetmaterial. Um eine Verformung des fertigen Targets und die Zerstörung der Si-Kacheln zu vermeiden müssen zwischen den einzelnen Si-Kacheln bestimmte Abstände eingehalten werden. Bei der Abkühlung rutschen die Kacheln aufeinander und die Zwischenspalte werden schmaler. Sind die Zwischenspalte bei der hohen Temperatur zu knapp eingestellt oder teilweise mit Kleberresten gefüllt, dann werden die Kacheln mit enormer Kraft aufeinander gepreßt, was zur Zerstörung des Targetmaterials während des Sputterprozesses führt. Sind die Zwischenspalte zu breit eingestellt, bleiben nach der Abkühlung unaufgefüllte Spalten zwischen einzelnen Targetteilen, was zu Instabilitäten (Arcing) des Sputterprozesses führt, weshalb die Abstände zwischen den einzelnen Kacheln außerordentlich genau bemessen sein müssen, wobei die Klebereste aus den Stoßfugen restlos entfernt werden müssen.

Um eine Zerstörung des kompletten Targets durch Verformen beim Transport und bei der Montage zu vermeiden, muß die Targetgrundplatte eine bestimmte Steifheit aufweisen. Dies wird durch eine entsprechende Dicke (je nach Targetlänge 6-10 mm) der Targetgrundplatte gewährleistet.

Gelötete Targets haben in der Regel einen sehr guten Wärmekontakt und eine hohe Haftung des Materials zur Grundplatte. Die Lötprozedur verläuft ähnlich wie beim Kleben, obwohl das Targetmaterial hier besonders vorbereitet sein muß. Auf der Bondfläche des Targets werden zuerst eine oder mehrere Metallschichten abgeschieden, die eine feste Verbindung zwischen Lot und Targetmaterial gewährleisten. Der Lötprozeß findet bei einer Temperatur von über 100° C statt. Die Probleme, die mit der Targetabkühlung verbunden sind, gleichen denjenigen die beim Targetkleben auftreten.

Der vorliegenden Erfindung liegt nun die Aufgabe zugrunde ein Target aus brüchigen Materialien, wie z.B. Si oder ITO, für Magnetrongroßkathoden zu schaffen, bei dem die Stoßfugen zwischen den einzelnen Targetstücken auf ein Minimum reduziert sind, bei dem der Targetwechsel besonders einfach zu bewerkstelligen ist und bei dem die Gefahr der Targetbeschädigung beim Transport und beim Targetwechsel auf ein Mindestmaß reduziert ist. Darüberhinaus soll das Ausgasen von Kleberesten während des Sputterprozesses ausgeschlossen werden.

Diese Aufgabe wird erfindungsgemäß dadurch gelöst, daß die aus dem abzusputternden Werkstoff gebildeten Targetkacheln jeweils eine parallelepipede Konfiguration aufweisen und jeweils fest mit einer ähnlich dimensionierten Targetgrundplatte verlötet, verschweißt oder verklebt sind, wobei die Grundflächen der Targetgrundplatten in ihrer Länge geringfügig kleiner und in ihrer Breite geringfügig größer bemessen sind, als die Grundfläche der jeweils zugehörigen Targetkachel, wobei die in der Breite jeweils über den Rand der Targetkachel hinausragenden beiden Randpartien der Targetgrundplatten mit Hilfe von Pratzleisten fest am Kathodenkörper gehalten sind.

Weitere Einzelheiten und Merkmale der Erfindung sind in den Ansprüchen näher beschrieben und gekennzeichnet.

Die Erfindung läßt die verschiedenen Ausführungsmöglichkeiten zu; eine davon ist in den anhängenden Zeichnungen näher dargestellt die ein Target im Querschnitt, im Längsschnitt und in der Draufsicht zeigen.

Die Kathode besteht im wesentlichen aus dem trogförmigen Kathodenkörper 3, der mit diesem verlöteten Kühlmembrane 4, den Targetgrundplatten 5, 5', ... , den mit diesen verklebten oder verlöteten Targetkacheln 6, 6', ... und den beiden mit dem Kathodenkörper 3 verschraubten Pratzleisten 7, 8.

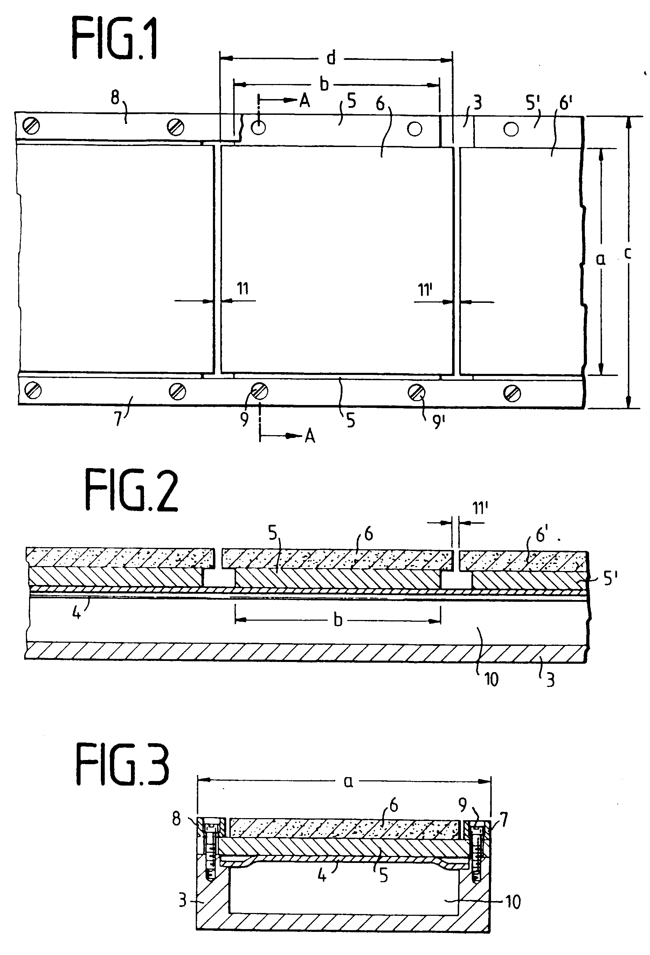

Wie aus Fig. 1 ersichtlich, sind die Targetkacheln 6, 6', ... und die Targetgrundplatten 5, 5', ... in ihren Grundflächen rechteckig ausgebildet, wobei jeweils des Breitenmaß a der Targetgrundplatte 5, 5', ... größer bemessen ist, als das Längenmaß b bei der Targetgrundplatte 5, 5', ... und wobei das Breitenmaß c der Targetkachel 6, 6', ... kürzer bemessen ist, als das Maß a und die Länge b der Targetgrundplatte 5, 5', ... wiederum kürzer ist, als die Länge d der Targetkachel 6, 6', ... .

Die seitlich über die Targetkachel 6, 6', ... hervorstehenden Randpartien der Targetgrundplatte 5, 5', ... sind mit Hilfe der beiden Pratzleisten 7, 8, deren Gesamtlänge jeweils der Gesamtlänge des trog- oder wannenförmigen Kathodenkörpers 3 entspricht, mit Hilfe von Schrauben 9, 9', ... am Kathodenkörper 3 befestigt. Die Unterseite der Targetgrundplatte 5, 5', ... liegt fest an der Oberseite der Metallmembrane 4 an, so daß ein guter Wärmeübergang von der durch den Kanal 10 strömenden Kühlflüssigkeit zu den Targetgrundplatten 5, 5', ... und damit auch zu den Targetkacheln 6,6... gewährleistet ist.

Die einzelnen Stoßfugen 11, 11', ... zwischen den jeweils benachbarten Targetkacheln 6, 6', ... sind so bemessen, daß die außerordentlich stoß- und druckempfindlichen Targetkacheln 6, 6', ... sich bei Erwärmung auf die Betriebstemperatur nicht berühren können.

Die einzelnen Targetkacheln 6, 6', ... sind auf den einzelnen bzw. Targetgrundplatten 5, 5', ... bei erhöhter Temperatur aufgeklebt oder aufgelötet. Nach dem Aushärten des Klebers oder Lots werden diese Targetkacheln auf Zimmertemperatur abgekühlt. Danach werden sie auf dem Kathodenkörper 3 dicht aneinander, ohne bzw. mit sehr geringem Abstand 11, 11', ... zu den benachbarten Kacheln 6, 6', ... befestigt, wobei eine Verschiebung der Targetkacheln längs des Kathodenkörpers 3 möglich bleibt. Diese Verschiebemöglichkeit kann mögliche Spannungen, die als Folge der thermischen Dehnung entstehen können, abbauen.

Es ist von besonderem Vorteil, daß die einzelnen Targetgrundplatten 5, 5', ... jeweils kürzer als die

Targetkacheln 6, 6', ... sind. Damit kann man auch bei nicht ganz parallelem Aufkleben oder Auflöten der Targetkacheln 6, 6', ... relativ zu den Seitenflächen des Kathodenkörpers 3 den Abstand 11, 11', ... zwischen jeweils benachbarten Targetkacheln auf beinahe Null setzen.

Der trog- oder wannenförmige Kathodenkörper 3, dessen den Targetkacheln 6, 6', ... zugekehrter oberer Rand mit der Membrane 4 verschweißt oder verlötet ist, weist Anschlüsse auf (nicht näher dargestellt) über die er in einen Kühlwasserkreislauf eingeschaltet ist, so daß die Unterseite der Membrane 4 während des Beschichtungsvorgangs ständig dem strömenden Kühlmittel ausgesetzt ist, wobei der Druck im Kühlkreislauf dafür Sorge trägt, daß die Membrane 4 mit ihrer Oberseite gut an der Unterseite der in einer Reihe angeordneten Targetgrundplatten 5, 5', ... anliegt und so auch eine gute Kühlung der Targetkacheln 6, 6', ... bewirkt.
Die Spalte 11, 11', ... zwischen den einzelnen Targetkacheln 6, 6', ... und die Länge b der Targetgrundplatten 5, 5', ... bzw. die zurückversetzten jeweils einander gegenüberliegenden Stirnflächen der Targetgrundplatten 5, 5', ... bewirken, daß etwa ausgasendes Lot oder Klebereste nicht zu unerwünschten Reaktionen im Bereich der Stoßfugen bzw. Spalte 11, 11', ... führen kann, so daß die die Stoßfugen 11, 11', ... bildenden Kanten während des Sputtervorgangs nicht erodieren oder in unerwünschter Weise abgetragen werden.

Als Material für die Targetgrundplatten 5, 5', ... kann Kupfer verwendet werden. Um aber die Spannungen zwischen Targetmaterial und Grundplatte, die auf Grund der unterschiedlichen Ausdehnungskoeffizienten entstehen (für Cu α = 16,6*10⁻⁶ °C und für Si α = 3,5*10⁻⁶°C) weiter abzubauen, kann Kupfer durch Molybdän (α = 5*10⁻⁶ °C) ersetzt werden. Der Molybdänpreis ist jedoch wesentlich höher als der Preis für Kupfer, weshalb sich nur dann Molybdän empfiehlt wenn es auch aus prozeßtechnischen Gründen zweckmäßig erscheint.

Die erfindungsgemäßen Vorteile sind:
* Der Abstand zwischen den einzelnen Targetkacheln 6, 6', ... wird praktisch auf Null reduziert und damit die Prozeßstabilität verbessert.
* Die zeitraubende und kostspielige Prozedur der Abstandshaltung zwischen benachbarten Targetkacheln und das Entfernen von Kleber oder Lot aus den Spalten 11, 11', ... zwischen den Targetkacheln 6, 6', ... vor der Targetabkühlung entfällt.
* Die Gefahr, daß durch Spannungen zwischen benachbarten Targetkacheln 6, 6', ... während der Abkühlungsprozedur die einzelnen Kacheln zerstört werden, besteht nicht mehr.
* Die Targetgrundplatte 5, 5', ... kann besonders dünnwandig gefertigt werden.
* Die Produktion von Targetkacheln 6, 6', ... auf Vorrat bietet sich an.
* Der Transport und die Lagerung des Targets ist einfacher. Einzelne Targetkacheln können in kleineren Kisten verpackt werden.
* Die Gefahr, daß beim Transport ein Target beschädigt wird, ist gering. (Die Verformung einer kurzen Platte (100 mm) mit gelötetem oder geklebtem Targetmaterial ist wesentlich kleiner als z.B. die Verformung eines 3750 mm langen Targets).
* Der Einbau des Targets in die Prozeßkammer wird vereinfacht.

## Patentansprüche

1. Target für die in einer evakuierbaren, mit einem Prozeßgas füllbaren Prozeßkammer angeordneten Kathode einer Vorrichtung zum Beschichten von Werkstücken mit einem Kathodenkörper (3) und mit einer Vielzahl auf dem Kathodenkörper in einer Reihe nebeneinanderliegend angeordneten, zusammen das Target bildenden Targetkacheln (6, 6', ...) und mit mindestens einer zwischen den Targetkacheln (6, 6', ...) und dem Kathodenkörper (3) angeordneten Targetgrundplatte (5, 5', ...), wobei die aus dem abzusputternden Werkstoff gebildeten Targetkacheln (6, 6', ...) jeweils eine parallelepipede Konfiguration aufweisen und jeweils fest mit einer ähnlich dimensionierten Targetgrundplatte (5, 5', ...) verlötet, verschweißt oder verklebt sind, wobei die Grundflächen der Targetgrundplatten (5, 5', ...) in ihrer Länge (b) geringfügig kleiner und in ihrer Breite (a) geringfügig größer bemessen sind, als die Grundfläche der jeweils zugehörigen Targetkachel (6, 6', ...), wobei die in der Breite jeweils über den Rand der Targetkachel (6, 6', ...) hervorstehenden beiden Randpartien der Targetgrundplatte (5, 5', ...) mit Hilfe von Pratzleisten (7,8) fest am Kathodenkörper(3) gehalten sind.

## Claims

1. A target for the cathode, arranged in a process chamber which can be evacuated and filled with a process gas, of a device for coating workpieces, comprising a cathode body (3), a plurality of target tiles (6, 6',...) which are arranged one beside another in a row on the cathode body and together form the target, and at least one target base plate (5, 5',...) arranged between the target tiles (6, 6',...) and the cathode body (3), wherein the target tiles (6, 6',...) which are formed from the material to be sputtered each have a parallelepiped configuration and are in each case firmly soldered, welded or glued to a target base plate (5, 5',...) of similar dimensions, the base surfaces of the target base plates (5, 5',...) being dimensioned so as to be slightly smaller in their length (b) and slightly greater in their breadth (a) compared to the base surface of the respective associated target tile (6, 6',...), and the two edge portions of the target base plate (5, 5',...), which in each case project laterally beyond the edge of the target tile (6, 6',...), being held firmly against the cathode body (3) with the aid of claw strips (7, 8).

## Revendications

1. Cible pour la cathode, disposée dans une chambre de processus mise sous vide et pouvant être remplie d'un gaz de processus, d'un dispositif pour revêtir des pièces, comportant un corps de cathode (3) et une pluralité de carreaux (6, 6', ...) disposés l'un à côté de l'autre en une rangée sur le corps de cathode et formant ensemble la cible, ainsi qu'au moins une plaque de base (5, 5', ...) de cible disposée entre les carreaux de cible (6, 6', ...) et le corps de cathode (3), dans le cas de laquelle les carreaux de cible (6, 6', ...), formés du matériau à déposer par pulvérisation, présentent chacun une configuration parallélépipédique et sont chacun brasés, soudés ou collés avec une plaque de base (5, 5', ...), de dimension analogue, de la cible, dans le cas de laquelle les surfaces de base des plaques de base (5, 5', ...) de la cible sont, en longueur (b), de dimension légèrement inférieure et, en largeur (a), de dimension légèrement supérieure à celles de la surface de base de chaque carreau correspondant (6, 6', ...) de la cible, les deux parties de bordure, dépassant chacune au-delà de la bordure du carreau (6, 6', ...) de la cible, de la plaque de base (5, 5', ...) étant fermement maintenues sur le corps de cathode (3) à l'aide de profilés de bridage (7, 8).
